Europäisches Patentamt

European Patent Office

Office européen des brevets

(11) Publication number: **0 057 446**
**B1**

# (12) EUROPEAN PATENT SPECIFICATION

(45) Date of publication of patent specification: **16.10.85**

(21) Application number: **82100637.6**

(22) Date of filing: **29.01.82**

(51) Int. Cl.⁴: **G 01 C 3/02, G 01 S 7/00,
H 03 K 17/78, F 16 M 11/00**

(54) **Surveying instrument having measuring mode selecting switch means.**

(30) Priority: **30.01.81 JP 12623/81**

(43) Date of publication of application:
**11.08.82 Bulletin 82/32**

(45) Publication of the grant of the patent:
**16.10.85 Bulletin 85/42**

(84) Designated Contracting States:
**CH DE FR GB LI SE**

(56) References cited:
**DE-A-2 814 934
DE-A-2 824 399
GB-A-2 017 297
US-A-3 832 056**

**Prospects: SOKKISHA SDM 3D; Hewlett
Packard 3820 A; WILD Tachymat T C 1**

(73) Proprietor: **TOKYO KOGAKU KIKAI KABUSHIKI
KAISHA
75-1, Hasunuma-cho Itabashi-ku
Tokyo (JP)**

(72) Inventor: **Tamaki, Hiroshi
Tokyo Kogaku Kikai K.K., No. 75-1 Hasunuma-
cho
Itabashi-ku Tokyo (JP)**
Inventor: **Kimura, Kazuaki
Tokyo Kogaku Kikai K.K., No. 75-1 Hasunuma-
cho
Itabashi-ku Tokyo (JP)**

(74) Representative: **Lorenz, Eduard et al
Widenmayerstrasse 23
D-8000 München 22 (DE)**

Courier Press, Leamington Spa, England.

## Description

### Background of Invention

The invention relates to a surveying instrument for electrically measuring angles and/or distances, comprising a base, a frame supported on said base for rotation about a vertical axis and having a pair of vertically extending substantially parallel posts, each of said posts having an outer side surface, a telescope supported on said posts for swinging movement about a horizontal axis extending between said posts, electric means provided in said frame for electrically detecting the angle of rotation of said frame about said vertical axis and the swinging angle of said telescope about said horizontal axis, and measuring mode selecting switch means for selecting one of a plurality of measuring modes of said electric means.

In recent years, electronic measures have widely been adopted in optical surveying instruments. For instance, developments have been made on electronic distance measuring transit including an electro-optical distance measuring instrument which is adapted to perform a distance measurement using a modulated photo-signals, as well as a transit telescope of which angle in a vertical and/or horizontal planes is measured by means of electric means such as encoders. Such electronic distance measuring transit instrument is provided with processing means which automatically measures the actual distance and the angle of elevation between the body of the surveying instrument and a target, and calculates the horizontal distance and the difference in elevation from the results of the measurements. For the purpose, the processing means generally includes a micro-computer, or the like, and the modes or programs of measurement and processing are appropriately selected by an operator through mode or program selecting switches provided on the instrument.

Conventionally, there has been known such an electronic distance measuring transit instrument that is provided on the stationary frame or the body of the transit telescope with the measuring-mode or program selecting switches, compare prospects of Electronic Distance Meter SDM 3D of SOKKISHA, Hewlett-Packard 3820A Electronic Total Station, and WILD Tachymat TC1 of Wild Heerbrugg.

However, in view of the fact that in the measuring instrument, for the purpose of increasing the accuracy of the measurements, the measurements are conducted in two different positions of the stationary frame and the telescope. More precisely, a first measurement is conducted with the stationary frame and the telescope in normal positions and they are then turned by 180° about their respective rotatable axes to perform a second measurement. Thus, in an arrangement wherein the mode or program selecting switches are located on the body of the telescope, it is required to provide such switches not only on the rear side of the stationary frame or the upper surface of the telescope body but also on the opposite side thereof in order to make it possible to actuate them both in the normal and turned-over positions of the telescope. Where the measuring-mode selecting switches are arranged on the tube of the telescope, they can be actuated in either position of the telescope since the switches are turned together with the telescope. However, in that case, difficulties will be encountered because the direction of actuation of the switches will have to be changed and indications on the switch panel will be turned over. Generally, the measuring modes or programs which are adapted to be selected by the measuring-mode selecting switches include the measurements of the actual distance, of the horizontal distance measurement, of the difference in elevation, as well as the measurements of the horizontal angle, of the zenith angle and of the elevation angle. Additionally, switches must be provided for utility systems such as a self-check switch, a weather compensation switch, a switch for indicating the inclination of the instrument itself, a print-out switch, a memory read-on switch, and so on.

Accordingly, such a surveying instrument requires ten or more selecting switches. Further, those measuring modes or programs have to be selected in every measuring point so that such measuring mode or program selecting switches are very often actuated. It should further be pointed out that conventional instruments adopted push-button type switches for the measuring mode or program selection, so that problems have been encountered in that the external force applied for the actuation of the switch may cause a measurement error because the instrument is aimed to perform measurements with the accuracy in the order of 1 mm or 1 sec of angle.

For the purpose of overcoming the problem inherent to such push button type switches, there has been proposed in the U.S. Patent 3,832,056 issued to John I. Shipp et al. to use as the ON-OFF switch for instructing the start of measurement a non-contact type switch including a light emitting diode and a light receiving diode which are so arranged that the light beam from the light emitting diode is reflected by a finger of the operator toward the light receiving diode to be sensed thereby. However, since the non-contact switch disclosed therein is of a reflecting type, it is apt to be influenced by external light. Further, such type of switches may undesirably be actuated simply when the operator moves his hand near the switch in order to operate any other switch, or they cannot be actuated where the operator wears gloves having too little reflectivity.

### Summary of the Invention

The present invention has been accomplished in view of the aforementioned problems of the conventional arrangements, and its object is to provide measuring mode or program selecting switches for an electronic distance measuring transit which are located so that they can readily be actuated even when the frame or the telescope is turned.

Another object of the present invention is to provide measuring mode or program selecting switches, which are of such a type that can be actuated by light beam interruption.

A further object of the present invention is to provide a distance measuring transit with non-contact type mode or program selecting switches which are substantially free from external influence.

According to the present invention, the above objects are accomplished by a surveying instrument for electrically measuring angles and/or distances as claimed in one of the independent claims 1, 2, 5 or 6.

More particularly, any one of the contactless switches comprises a photo-electric switch including a light emitting element and a light receiving element which are so arranged that the switch is actuated when the light flux between the elements is interrupted. According to the features of the present invention, it is possible to avoid any influence of external light or any misoperation even when the operator's hand is brought close to the switch. Further, the switch can be actuated even when the operator wears gloves. It is not required to provide more than one set of switches because the locations of the switches are not affected by the turning over of the telescope.

The above and other advantages and features will become apparent from the following descriptions of a preferred embodiment of the present invention taking reference to the accompanying drawings.

Description of the Drawings

Fig. 1 is a perspective view of a distance measuring transit in accordance with one embodiment of the present invention;

Fig. 2 is a sectional view taken along the line II—II in Fig. 1;

Fig. 3 is a sectional view showing a mode selection switch in accordance with another embodiment of the present invention;

Fig. 4 is a circuit diagram of a measuring mode selecting switch; and

Fig. 5 is a diagram showing wave-forms in various parts of the circuit in Fig. 4.

Description of the Preferred Embodiment

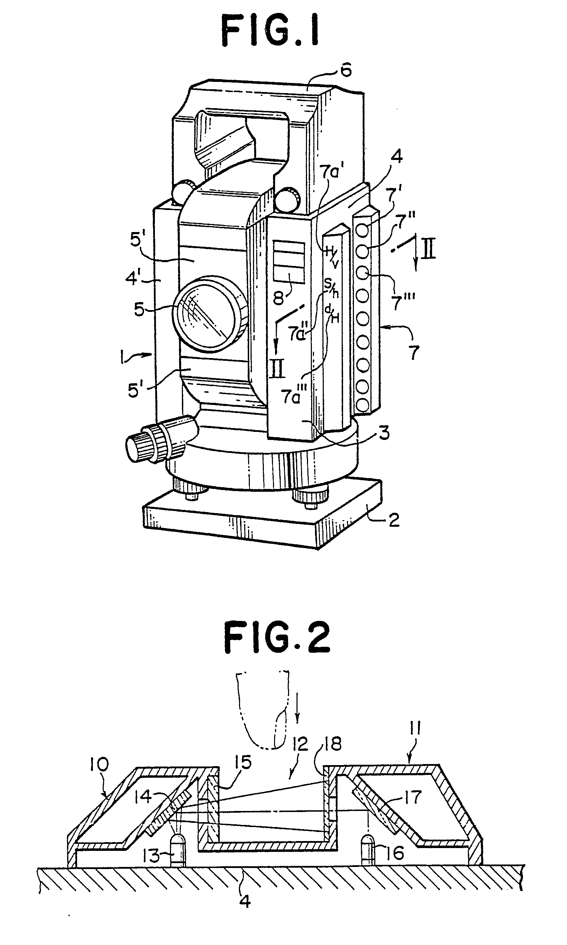

Referring to the drawings, particularly to Figure 1, there is shown a surveying instrument 1 for electrically measuring angles and distances which comprises a frame portion 3 provided rotatably on a base 2. The frame portion 3 consists of posts 4 and 4' and a carrying bar 6 which extends between the upper ends of the posts 4 and 4'. The posts 4 and 4' rotatably supports a transit telescope 5. The telescope 5 comprises a body 5' which supported for swinging movement about a horizontal axis on the posts 4 and 4' and carries a lens tube as in a conventional transit. In the body 5', there is provided a control device of a photoelectric distance measuring device. In the frame portion 3 and the post 4', there are housed an angle-measuring devices having encoders which function as detecting means. In the carrying bar 6, there is housed a battery (not shown). The post 4 is provided on the outer side surface with a measuring mode selecting switch assembly 7 of contactless type and on the front surface with an indicator 8 for indicating the measured values. The switch assembly 7 comprises a plurality of switches 7', 7'', 7'''... and on both sides of the switch assembly 7, there are provided identifications 7a', 7a'', 7a'''... for indicating the functions of the associated switches 7', 7'', 7'''..., respectively. Referring to Fig. 2, there is shown an example of switch which can be adopted in the switch assembly 7. As shown, the switch comprises a light emitting section 10, a light receiving section 11 and an actuating section 12 located between the sections 10 and 11. The light emitting section 10 consists of a light emitting element 13 radiating infrared ray, a reflection mirror 14 and a dust-proof glass 15, and the light receiving section 11 consists of a light receiving element 16, a reflection mirror 17 and a wavelength selecting filter 18. The sections 10 and 11 are so arranged that the light from the element 13 is reflected by the mirror 14 and passed through the glass 15 and then through the section 12 and the filter 18 to the mirror 17 to be reflected thereby toward the element 16. The switch can be actuated by inserting a finger into the section 12 to block the light between the elements 13 and 16.

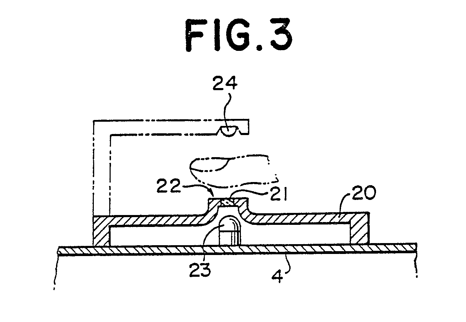

Referring to Fig. 3, which shows another embodiment, the switch includes a switch housing 20 provided with a window opening 22 having a dust-proof glass 21. In the switch housing 20, there is provided a light receiving element 23. The light receiving element 23 is normally in ON position as far as the external light is received through the window 22. The switch can be actuated by covering the window 22 to block the light to the element 23. A light source 24 may be provided to illuminate the element 23 when it is desired to use the instrument in dark such as in a tunnel or at night.

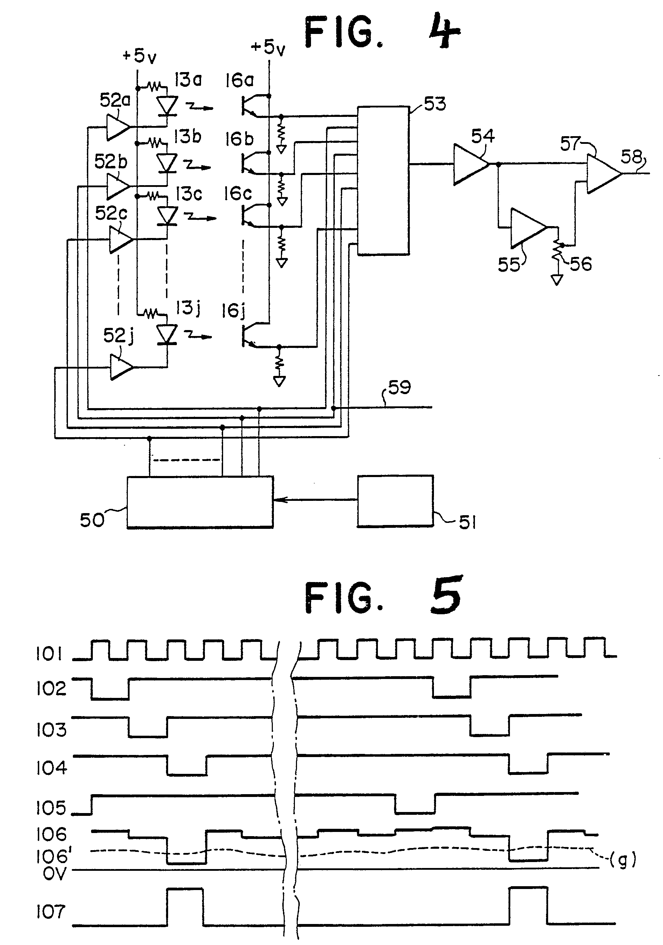

Referring now to Figures 4 and 5, descriptions will be made on the electric circuit for the measuring mode selecting switch assembly 7. In the embodiment shown in Fig. 4, the switch assembly 7 consists of ten light emitting elements, for example, light emitting diodes 13a through 13j and corresponding number of light receiving elements, for example, photodiodes 16a through 16j. There is provided a scanning circuit 50 which consists of a counter and a decoder for scanning light emitting element drives 52a through 52j. An oscillator 51 is associated with the circuit 50 to apply a clock pulse 101 as shown in Figure 5 to the circuit 50. The circuit 50 energizes the drivers 52a through 52j upon receipt of the clock pulse 101. The output signals from the drivers 52a, 52b, 52c, 52j are shown by numerals 102, 103, 104, 105 in Figure 5, respectively. The light receiving elements 16a through 16j are connected with an analogous switch 53 which is in turn connected with an amplifier 54. The switch 53 is also connected with the scanning circuit 50 so that it can be scanned in synchronism with the scanning of light emitting elements 13a through 13j. Thus, when any one of the photo-emitting elements 13 is energized to emit the modulated light, the output of the corresponding light receiving element 16 is passed to the amplifier 54. The output of the analogous switch 53 is shown in Figure 5 by the numerals 106 which indicates the signal as produced when the space between the light emitting element 13c and the light receiving element 16c is blocked to interrupt transmittal of light. The outputs of light receiving elements 16a through 16j are sequentially passed to the amplifier 54 in synchronism with the clock pulses from the oscillating circuit 51. The output 106, which has been amplified to a suitable level by the amplifier 54, is applied to the input terminal of an averaging circuit 55 and one of the input terminals of a comparative circuit 57. The circuit 55 functions to provide an average of signals supplied from the amplifier 54 for a predetermined period which is substantially long as compared with the scanning frequencies of the light emitting elements 13a through 13j. The output of the averaging circuit 55 is applied through a voltage divider 56 to the other input terminal of the comparative circuit 57. The signal which has passed through the voltage divider 56 is shown by the numeral 106' and functions as a reference level which is effective to eliminate or decrease the influence of external light on the switch.

The comparative circuit 57 serves to compare the amplitude of the output 106 of the amplifier 54 with the amplitude of the output 106' of the voltage divider 56, and produce binary signals which are applied to a signal line 58. As shown in Figure 5, where the space between the light emitting element 13c and the light receiving element 16c is blocked to interrupt the light to pass therethrough, the output 107 becomes high level at the timing corresponding to the output of the element 16c. The signal line 58 is connected to the input line of a microprocessor which is not shown. The signal line 59, which supplies timing pulses (for example, pulses generated by the light emitting element 13c) for giving the scanning position reference, is connected to one of the input lines of the above-mentioned microprocessor. The microprocessor functions to detect the time interval until the input thereto is changed to a lower level to thereby judge which one of the switches is actuated and performs the measuring and processing operations.

The illustrated embodiment is advantageous in that since the photoelectric switches are sequentially scanned, it becomes unnecessary to energize a plurality of light emitting diodes at the same time so that the electric power consumption can be reduced and the electric circuit can be of simple construction.

As an alternative arrangement, the measuring mode selecting switch assembly 7 may be positioned on the carrying bar 6. Further, a partition plate may be provided between individual switches for the purpose of avoiding erreoneous actuation of the switches due to leaking light.

## Claims

1. A surveying instrument for electrically measuring angles and/or distances, comprising: a base (2), a frame (3) supported on said base (2) for rotation about a vertical axis and having a pair of vertically extending substantially parallel posts (4, 4'), each of said posts (4, 4') having an outer side surface, a telescope (5, 5') supported on said posts (4, 4') for swinging movement about a horizontal axis extending between said posts (4, 4'), electric means provided in said frame (3) for electrically detecting the angle of rotation of said frame (3) about said vertical axis and the swinging angle of said telescope (5, 5') about said horizontal axis, and measuring mode selecting switch (7) for selecting one of a plurality of measuring modes of said electric means; characterized in that said measuring mode selecting switch means comprises: contactless type switch means (7', 7'', 7''', 7a', 7a'', 7a''') including a plurality of light emitting elements (13, 13a—13j) arranged on at least one of said outer side surfaces of said posts (4, 4') in at least one row along a lengthwise direction of said post, a plurality of light receiving elements (16, 16a—16j) arranged on said one of said outer side surfaces of said posts (4, 4') in at least one row which is parallel with the row of said light emitting elements (13, 13a—13j), said light receiving elements (16, 16a—16j) being respectively paired with said light emitting elements (13, 13a—13j) so that the light beams from respectively ones of the light emitting elements (13, 13a—13j) are received by the paired ones of the light receiving elements (16, 16a—16j), a switch actuating space (12) being provided beween each light emitting element (13, 13a—13j) and the light receiving element (16, 16a—16j) which is paired with said light emitting element (13, 13a—13j) so that the light beam from the light emitting element (13, 13a—13j) is blocked when a light blocking substance is inserted into the switch actuating space (12), drive means (52a—52j) for driving the pairs of the light emitting (13, 13a—13j) and light receiving (16, 16a—16j) elements one by one on time sharing basis, means for detecting a pair of the light emitting elements (13, 13a—13j) and the light receiving elements (16, 16a—16j) wherein the switch actuating space (12) is blocked and determine the measuring mode in accordance with the result of the detection.

2. A surveying instrument for electrically measuring angles and/or distances, comprising: a base (2), a frame (3) supported on said base (2) for rotation about a vertical axis and having a pair of vertically extending substantially parallel posts (4, 4'), a telescope (5, 5') supported on said posts (4, 4') for swinging movement about a horizontal axis extending between said posts (4, 4'), a carrying bar (6) extending between upper ends of said posts (4, 4'), electric means provided in said frame (3) for electrically detecting the angle of rotation of said frame (3) about said vertical axis and the swinging angle of said telescope (5, 5') about said horizontal axis, and measuring mode selecting switch means (7) for selecting one of a plurality of measuring modes of said electric means; characterized in that said measuring mode selecting switch means (7) comprises contactless type switch means (7', 7'', 7''') including a plurality of light emitting elements (13, 13a—13j) arranged on said carrying bar (6) and a plurality of light receiving elements (16, 16a—16j) arranged on said carrying bar (6), said light receiving elements (16, 16a—16j) being respectively paired with said light emitting elements (13, 13a—13j) so that the light beams from respective ones of the light emitting elements (13, 13a—13j) are received by the paired ones of the light receiving elements (16, 16a—16j), a switch actuating space (12) being provided between each light emitting element (13, 13a—13j) and the light receiving element (16, 16a—16j) which is paired with said light emitting element (13, 13a—13j) so that the light beam from the light emitting element (13, 13a—13j) is blocked when a light blocking substance is inserted into the switch actuating space (12), drive means (52a—52j) for driving the pairs of the light emitting (13, 13a—13j) and the light receiving elements (16, 16a—16j) one by one on time sharing basis, means for detecting a pair of the light emitting elements (13, 13a—13j) and the light receiving elements (16, 16a—16j) wherein the switch actuating space (12) is blocked and determine the measuring mode in accordance with the result of the detection.

3. A surveying instrument in accordance with claim 1 or 2 in which said light emitting elements (13, 13a—13j) are of such type that radiates light beams of a specific wavelength band and said light receiving elements (16, 16a—16j) are of such type that is responsive to the said light beams of said specific wavelength band.

4. A surveying instrument in accordance with claim 3 in which said light emitting elements (13, 13a—13j) are of such type that radiates infra-red rays.

5. A surveying instrument for electrically measuring angles and/or distances, comprising: a base (2), a frame (3) supported on said base (2) for rotation about a vertical axis and having a pair of vertically extending substantially parallel posts (4, 4'), each of said posts (4, 4') having an outer side surface, a telescope (5, 5') supported by said posts (4, 4') for swinging movement about a horizontal axis extending between said posts (4, 4'), electric means provided in said frame (3) for electrically detecting the angle of rotation of said frame (3) about said vertical axis and the swinging angle of said telescope (5, 5') about said horizontal axis, and measuring mode selecting switch means (7) for selecting one of a plurality of measuring modes of said electric means; characterized in that said measuring mode selecting switch means (7) comprises: contactless type switch means (7', 7'', 7''') including a plurality of light receiving elements (23) arranged on at least one of said outer side surface of said posts (4, 4') along the length of the posts (4, 4') for receiving external light; drive means for sequentially driving said light receiving elements (23) on a time sharing basis; and discriminating means for discriminating a light receiving element (23) which is covered and thereby is prevented from receiving the external light and for determining a measuring mode in accordance with the result of the discrimination.

6. A surveying instrument for electrically measuring angles and/or distances, comprising: a base (2), a frame (3) supported on said base (2) for rotation about a vertical axis and having a pair of vertically extending substantially parallel posts (4, 4'), a telescope (5, 5') supported by said posts (4, 4') for swinging movement about a horizontal axis extending between said posts (4, 4'), a carrying bar (6) extending between upper ends of said posts (4, 4'), electric means provided in said frame (3) for electrically detecting the angle of rotation of said frame (3) about said vertical axis and the swinging angle of said telescope (5, 5') about said horizontal axis, and measuring mode selecting switch means (7) for selecting one of a plurality of measuring modes of said electric means; characterized in that said measuring mode selecting switch means (7) comprises: a contactless type switch means (7', 7'', 7''') including a plurality of light receiving elements (23) provided on said carrying bar (6) for receiving an external light; drive means for sequentially driving said light receiving elements on a time sharing basis; and discriminating means for discriminating a light receiving element which is covered and thereby is prevented from receiving external light and for determining a measuring mode in accordance with the result of the discrimination.

7. A surveying instrument according to claim 5 or 6 wherein said contactless type switch means further includes light source means (24) for illuminating the light receiving elements (23), said light source means (24) being located with a spacing with respect to the light receiving elements (23).

**Revendications**

1. Instrument topographique pour la mesure électrique d'angles et/ou de distances comportant un support (2), un bâti (3) supporté par le support (2) pour tourner autour d'un axe vertical et ayant une paire de montants (4, 4') verticaux essentiellement parallèles, chacun desdits montants (4, 4') ayant une surface latérale extérieure, un télescope (5, 5') supporté par lesdits montants (4, 4') pour effectuer un mouvement oscillant autour d'un axe horizontal s'étendant entre lesdits montants (4, 4'), des moyens électriques prévus dans ledit bâti (3) pour détecter électriquement l'angle de rotation dudit bâti (3) autour dudit axe vertical et l'angle d'oscillation dudit télescope (5, 5') autour dudit axe horizontal et des moyens de commutation (7) pour la sélection du mode de mesure pour la sélection d'un parmi une pluralité de modes de mesure desdits moyens électriques, caractérisé en ce que lesdits moyens de commutation pour la sélection du mode de mesure comportent des moyens de commutation du type sans contact (7', 7'', 7''', 7a', 7a'', 7a''') comportant une pluralité d'éléments émettant de la lumière (13, 13a à 13j) disposés sur au moins une desdites surfaces latérales extérieures desdits montants (4, 4') dans au moins une rangée le long de la direction longitudinale dudit montant, une pluralité d'éléments de réception de lumière (16, 16a à 16j) disposés sur ladite surface des surfaces latérales extérieures desdits montants (4, 4') en au moins une rangée disposée parallèlement à la rangée desdits éléments d'émission de lumière (13, 13a, à 13j), lesdits éléments de réception de lumière (16, 16a à 16j) correspondant chacun à un desdits éléments d'émission de lumière (13, 13a à 13j) de manière à ce que les rayons de lumière partant d'un des éléments d'émission de lumière (13, 13a à 13j) sont reçus par l'élément correspondant de réception de lumière (16, 16a à 16j), un espace (12) d'actionnement du commutateur étant prévu entre chaque élément d'émission de lumière (13, 13a à 13j) et l'élément de réception de lumière (16, 16a à 16j) correspondant de sorte que le rayon de lumière partant de l'élément d'émission de lumière (13, 13a à 13j) est bloqué lorsqu'une substance de blocage de la lumière est insérée dans l'espace (12) d'actionnement du commutateur, des moyens d'entraînement (52a à 52j) pour entraîner les paires d'éléments d'émission (13, 13a à 13j) et de réception de lumière (16, 16a à 16j), les unes après les autres sur la base du partage du temps, des moyens pour détecter une paire d'éléments d'émisson (13, 13a à 13j) et de réception de lumière (16, 16a à 16j), moyens de détection dans lesquels l'espace (12) d'actionnement du commutateur est bloqué et qui déterminent le mode de mesure conformément au résultat de la détection.

2. Instrument topographique pour la mesure électrique d'angles et/ou de distances comportant un support (2), un bâti (3) supporté par ledit support (2) pour tourner autour d'un axe vertical ayant une paire de montants verticaux essentiellement parallèles (4, 4'), un télescope (5, 5') supporté par lesdits montants (4, 4') pour effectuer un mouvement oscillant autour d'un axe horizontal s'étendant entre les deux montants (4, 4'), une barre de support (6) s'étendant entre les extrémités supérieures desdits montants (4, 4'), des moyens électroniques pourvus dans ledit bâti (3) pour détecter électriquement l'angle de rotation dudit bâti (3) autour dudit axe vertical et l'angle d'oscillation du télescope (5, 5') autour dudit axe horizontal, et des moyens de commutation (7) pour la sélection du mode de mesure pour sélectionner un parmi une pluralité de modes de mesure desdits moyens électriques caractérisé en ce que lesdits moyens de commutation (7) pour sélectionner le mode de mesure comportent des moyens de commutation du type sans contact (7) comportant une pluralité d'éléments d'émission de lumière (13, 13a à 13j) disposés sur ladite barre de support (6), une pluralité d'éléments recevant la lumière (16, 16a à 16j) disposés sur ladite barre de support (6), lesdits éléments de réception de lumière (16, 16a à 16j) correspondant chacun à un desdits éléments d'émission de lumière (13, 13a à 13j) de manière à ce que les rayons de lumière provenant d'un élément d'émission de lumière (13, 13a à 13j) sont reçus par l'élément correspondant de réception de lumière (16, 16a à 16j), un espace (12) d'actionnement du commutateur étant prévu entre chaque élément d'emission de lumière (13, 13a à 13j) et l'élément correspondant recevant la lumière (16, 16a à 16j) de manière à ce que le rayon partant de l'élément d'émission de lumière (13, 13a à 13j) est bloqué lorsqu'une substance de blocage est insérée dans l'espace (12), d'actionnement du commutateur, des moyens d'entraînement (52a à 52j) pour entraîner les paires d'éléments d'émission (13, 13a à 13j) et de réception de lumière (16, 16a à 16j), les unes après les autres et sur la base du partage du temps, des moyens pour détecter une paire d'éléments d'émission (13, 13a à 13j) et de réception de lumière (16, 16a à 16j) entre lesquels l'espace (12) d'actionnement du commutateur est bloqué et pour déterminer le mode de mesure conformément au résultat de la détection.

3. Instrument topographique selon les revendications 1 ou 2 caractérisé en ce que lesdits éléments d'émission de lumière (13, 13a à 13j) sont du type qui émet des rayons de lumière dans une bande de longueurs d'onde spécifique et que lesdits éléments de réception de lumière (16, 16a à 16j) sont du type qui réagit aux rayons de lumière de ladite bande de longueurs d'onde spécifique.

4. Instrument topographique selon la revendication 3 caractérisé en ce que lesdits éléments d'émission de lumière (13, 13a à 13j) sont du type qui émet des rayons infrarouges.

5. Instrument topographique pour la mesure électrique d'angles et/ou de distances comportant un support (2), un bâti (3) supporté par ledit support (2) pour tourner autour d'un axe vertical ayant une paire de montants (4, 4') verticaux et substantiellement parallèles, chacun desdits montants (4, 4') ayant une surface latérale extérieure, un télescope (5, 5') supporté par lesdits montants (4, 4') pour effectuer un mouvement oscillant autour d'un axe horizontal s'étendant entre lesdits montants (4, 4'), des moyens électriques pourvus dans ledit bâti (3) pour détecter électriquement l'angle de rotation autour dudit axe vertical dudit bâti et l'angle d'oscillation dudit télescope (5, 5') autour dudit axe horizontal et des moyens de commutation (7) pour la sélection du mode de mesure pour sélectionner un parmi une pluralité de modes de mesure des dits moyens électriques caractérisé en ce que lesdits moyens de commutation (7) pour la sélection du mode de mesure comportent des moyens de commutation (7', 7'', 7''') du type sans contact comportant une pluralité d'éléments recevant la lumière (23) disposés sur au moins une des surfaces latérales extérieures desdits montants (4, 4') le long de la longueur des montants (4, 4') pour recevoir de la lumière de l'extérieur, des moyens d'entraînement pour entraîner successivement lesdits éléments de réception de lumière (23) sur la base du partage du temps, et des moyens de discrimination pour distinguer un élément de réception de lumière (23) qui est couvert et est ainsi empêche de recevoir de la lumière de l'éxtérieur et pour déterminer un mode de mesure conformément avec le résultat de la discrimination.

6. Instrument topographique pour mesurer électriquement des angles et/ou des distances comportant un support (2), un bâti (3) supporté par ledit support (2) pour tourner autour d'un axe vertical ayant une paire de montants verticaux substantiellement parallèles (4, 4'), un télescope (5, 5') supporté par lesdits montants (4, 4') pour effectuer un mouvement oscillant autour d'un axe horizontal s'étendant entre lesdits montants (4, 4'), une barre de support (6) s'étendant entre les extrémités supérieures desdits montants (4, 4'), des moyens électriques pourvus dans ledit bâti (3) pour détecter électriquement l'angle de rotation dudit bâti (3) autour dudit axe vertical et l'angle d'oscillation dudit télescope (5, 5') autour dudit axe horizontal, et des moyens de commutation (7) pour la sélection du mode de mesure pour sélectionner un parmi une pluralité de modes de mesure desdits moyens électriques, caractérisé en ce que lesdits moyens de commutation (7) de sélection du mode de mesure comportent des moyens de commutation (7', 7'', 7''') du type sans contact comportant une pluralité d'éléments de réception de lumière (23) disposés sur ladite barre de support (6) pour recevoir de la lumière de l'extérieur, des moyens d'entraînement pour entraîner successivement lesdits éléments de réception de lumière sur la base du partage du temps et des moyens de discrimination pour discerner un élément de réception de lumière qui est couvert et est ainsi empéché de recevoir de la lumière de l'extérieur et pour déterminer un mode de mesure conformément au résultat de la discrimination.

7. Instrument topographique selon les revendications 5 ou 6 caractérisé en ce que les moyens de commutation du type sans contact comportent, par ailleurs, des moyens de sources de lumière (24) pour éclairer les éléments de réception de lumière (23), lesdits moyens de sources lumineuses (24) étant logés à une certaine distance par rapport aux éléments de réception de lumière (23).

**Patentansprüche**

1. Vermessungsinstrument zum elektrischen Messen von Winkeln und/oder Strecken, mit einem Sockel (2), einem auf dem Sockel (2) um eine Vertikalachse drehbar angebrachten Gestell (3) mit zwei vertikal stehenden praktisch parallelen Pfosten (4, 4'), die jeweils eine äußere Seitenfläche besitzen, mit einem an den Pfosten (4, 4') angebrachten Fernrohr (5, 5'), das um eine zwischen den Pfosten (4, 4') sich erstreckende Horizontalachse verschwenkbar ist, mit einer in dem Gestell (3) untergebrachten elektrischen Einrichtung für den elektrischen Nachweis des Winkels der Drehung des Gestells (3) un die Vertikalachse und des Schwenkwinkels des Fernrohrs (5, 5') um die Horizontalachse, und mit einer Schalteinrichtung (7) für die Wahl des Meßprogramms, um eines von einer Mehrzahl von Meßprogrammen der elektrischen Einrichtung wählen zu können, dadurch gekennzeichnet, daß diese Schalteinrichtung für die Wahl des Meßprogramms gebildet ist von einer kontaktfreien Schalteinrichtung (7', 7'', 7''', 7a', 7a'', 7a'''), die eine Mehrzahl von lichtemittierenden Elementen (13, 13a, bis 13j) aufweist, die an mindestens einer der äußeren Seitenflächen der Pfosten (4, 4') in mindestens einer Reihe in Längsrichtung der Pfosten angeordnet sind, von einer Mehrzahl von lichtaufnehmenden Elementen (16, 16a bis 16j), die an dieser eine äußeren Seitenfläche der Pfosten (4, 4') in mindestens einer Reihe angeordnet sind, die parallel zu der Reihe der lichtemittierenden Elemente (13, 13a bis 13j) verläuft, wobei jeweils eines der lichtaufnehmenden Elemente (16, 16a bis 16j) jeweils einem der lichtemittierenden Elemente (13, 13a bis 13j) zugeordnet ist, so daß die von jeweils einem der lichtemittierenden Elemente (13, 13a bis 13j) ausgehenden Lichtstrahlen von dem jeweils zugeordneten lichtaufnehmenden Element (16, 16a, 16j) aufgenommen werden, und wobei ein Schalterbetätigungszwischenraum (12) zwischen jedem lichtemittierenden Element (13, 13a bis 13j) und dem ihm jeweils zugeordneten lichtaufnehmenden Element (16, 16a bis 16j) vorgesehen ist, so daß der von dem lichtemittierenden Element (13, 13a bis 13j) audgehende Lichtstrahl blockiert wird, wenn eine lichtabschirmende Substanz in den Schalterbetätigungszwischenraum (12) eingeführt wird, von einem Aussteuermittel (52a bis 52j) zum Aussteuern der jeweils einander zugeordneten lichtemittierenden (13, 13a bis 13j) und lichtaufnehmenden (16, 16a bis 16j) Elemente nacheinander im Zeitmultiplexbetrieb, von einer Einrichtung zum Nachweisen eines lichtemittierenden Elements (13, 13a bis 13j) und des jeweils zugeordneten lichtaufnehmenden Elements (16, 16a bis 16j), zwischen denen der Schalterbetätigungszwischenraum (12) blockiert ist, und zum Bestimmen des Meßprogramms in Übereinstimmung mit dem Ergebnis des Nachweises.

2. Vermessungsinstrument zum elektrischen Messen von Winkeln und/oder Strecken, mit einem Sockel (2), einem auf dem Sockel (2) um eine Vertikalachse drehbar angebrachten Gestell (3) mit zwei vertikal stehenden, praktisch parallelen Pfosten (4, 4'), mit einem an den Pfosten (4, 4') angebrachten Fernrohr (5, 5'), das um eine zwischen den Pfosten (4, 4') sich erstreckende Horizontalachse verschwenkbar ist, mit einer von den oberen Enden der Pfosten (4, 4') ausgehenden Tragstange (6), mit einer in dem Gestell (3) untergebrachten elektrischen Einrichtung für den elektrischen Nachweis des Winkels der Drehung des Gestells (3) um die Vertikalachse und des Schwenkwinkels des Fernrohrs (5, 5') un die Horizontalachse, und mit einer Schalteinrichtung (7) für die Wahl des Meßprogramms, um eines von einer Mehrzahl von Meßprogrammen der elektrischen Einrichtung wählen zu können, dadurch gekennzeichnet, daß die Schalteinrichtung (7) für die Wahl des Meßprogramms gebildet ist von einer kontaktfreien Schalteinrichtung (7', 7'', 7'''), die eine Mehrzahl von lichtemittierenden Elementen (13, 13a bis 13j) umfaßt, die an der Tragstange (6) angebracht sind, und eine Mehrzahl von lichtaufnehmenden Elementen (16, 16a bis 16j), die an der Tragstange (6) angeordnet sind, wobei jeweils eines der lichtaufnehmenden Elemente (16, 16a bis 16j) jeweils einem der lichtemittierenden Elemente (13, 13a bis 13j) zugeordnet ist, so daß die von jeweils einem der lichtemittierenden Elemente (13, 13a bis 13j) ausgehenden Lichtstrahlen von dem jeweils zugeordneten lichtaufnehmenden Element (16, 16a bis 16j) aufgenommen werden, wobei ein Schalterbetätigungszwischenraum (12) zwischen jedem lichtemittierenden Element (13, 13a bis 13j) und dem ihm jeweils zugeordneten lichtaufnehmenden Element (16, 16a bis 16j) vorgesehen ist, so daß der von dem lichtemittierenden Element (13, 13a bis 13j) ausgehende Lichtstrahl blockiert wird, wenn eine lichtabschirmende Substanz in den Schalterbetätigungszwischenraum (12) eingeführt wird, von einem Aussteuermittel (52a bis 52j) zum Aussteuern der jeweils einander zugeordneten lichtemittierenden (13, 13a bis 13j) und lichtaufnehmenden (16, 16a bis 16j) Elemente nacheinander im Zeitmultiplexbetrieb, von einer Einrichtung zum Nachweisen eines lichtemittierenden Elements (13, 13a bis 13j) und des jeweils zugeordneten lichtaufnehmenden Elements (16, 16a bis 16j), zwischen denen der Schalterbetätigungszwischenraum (12) blockiert ist, und zum Bestimmen des Meßprogramms in Übereinstimmung mit dem Ergebnis des Nachweises.

3. Vermessungsinstrument nach Anspruch 1 oder 2, dadurch gekennzeichnet, daß die lichtemittierenden Elemente (13, 13a bis 13j) so ausgebildet sind, daß sie die Lichtstrahlen eines bestimmten Wellenlängenbandes aussenden, und daß die lichtaufnehmenden Elemente (16, 16a bis 16j) so ausgebildet sind, daß sie für die Lichtstrahlen dieses bestimmten Wellenlängenbandes empfindlich sind.

4. Vermessungsinstrument nach Anspruch 3, dadurch gekennzeichnet, daß die lichtemittierenden Elemente (13, 13a bis 13j) infrarote Strahlung aussenden.

5. Vermessungsinstrument zum elektrischen Messen von Winkeln und/oder Strecken, mit einem Sockel (2), einem auf dem Sockel (2) um eine Vertikalachse drehbar angebrachten Gestell (3) mit zwei vertikal stehenden, praktisch parallelen Pfosten (4, 4'), die jeweils eine äußere Seitenfläche besitzen, mit einem an den Pfosten (4, 4') angebrachten Fernrohr (5, 5'), das um eine zwischen den Pfosten (4, 4') sich erstreckende Horizontalachse verschwenkbar ist, mit einer in dem Gestell (3) untergebrachten elektrischen Einrichtung für den elektrischen Nachweis des Winkels der Drehung des Gestells (3) um die Vertikalachse und des Schwenkwinkels des Fernrohrs (5, 5') um die Horizontalachse, und mit einer Schalteinrichtung (7) für die Wahl des Meßprogramms, um eines von einer Mehrzahl von Meßprogrammen der elektrischen Einrichtung wählen zu können, dadurch gekennzeichnet, daß die Schalteinrichtung (7) für die Wahl des Meßprogramms gebildet ist von einer kontaktfreien Schalteinrichtung (7', 7'', 7'''), die eine Mehrzahl von lichtaufnehmenden Elementen (23) umfaßt, die auf mindestens einer der äußeren Seitenflächen der Pfosten (4, 4') längs dieser Pfosten (4, 4') angeordnet sind, um Licht von außen aufzunehmen, von einem Aussteuermittel zum sequentiellen Aussteuern der lichtaufnehmenden Elemente im Zeitmultiplexbetrieb, und von einer Diskriminatoreinrichtung zum Unterscheiden eines lichtaufnehmenden Elements (23), das verdeckt ist und daher kein Licht von außen aufnehmen kann, und zum Bestimmen eines Meßprogramms in Übereinstimmung mit dem Ergebnis der Unterscheidung.

6. Vermessungsinstrument zum elektrischen Messen von Winkeln und/oder Strecken, mit einem Sockel (2), einem auf dem Sockel (2) um eine Vertikalachse drehbar angebrachten Gestell (3) mit zwei vertikal stehenden, praktisch parallelen Pfosten (4, 4'), mit einem an den Pfosten (4, 4') angebrachten Fernrohr (5, 5'), das um eine zwischen den Pfosten (4, 4') sich erstreckende Horizontalachse verschwenkbar ist, mit einer von den oberen Enden der Pfosten (4, 4') ausgehenden Tragstange (6), mit einer in dem Gestell (3) untergebrachten elektrischen Einrichtung für den elektrischen Nachweis des Winkels der Drehung des Gestells (3) um die Vertikalachse und des Schwenkwinkels des Fernrohrs (5, 5') um die Horizontalachse, und mit einer Schalteinrichtung (7) für die Wahl des Meßprogramms, um eine von einer Mehrzahl von Meßprogrammen der elektrischen Einrichtung wählen zu können, dadurch gekennzeichnet, daß die Schalteinrichtung (7) für die Wahl des Meßprogramms gebildet ist von einer kontaktfreien Schalteinrichtung (7', 7'', 7'''), die eine Mehrzahl von lichtaufnehmenden Elementen (23) umfaßt, die an dem Tragstab (6) zum Aufnehmen eines von außen kommenden Lichts angeordnet sind, von einem Aussteuermittel zum sequentiellen Aussteuern der lichtaufnehmenden Elemente im Zeitmultiplexbetrieb, und von einer Diskriminatoreinrichtung zum Unterscheiden eines lichtaufnehmenden Elements, das verdeckt ist und daher kein Licht von außen aufnehmen kann, und zum Bestimmen eines Meßprogramms in Übereinstimmung mit dem Ergebnis der Unterscheidung.

7. Vermessungsinstrument nach Anspruch 5 oder 6, dadurch gekennzeichnet, daß die kontaktfreie Schalteinrichtung außerdem Lichtquellen (24) zum Beleuchten der lichtaufnehmenden Elemente (23) aufweist, wobei die Lichtquellen (24) mit Abstand von den lichtaufnehmenden Elementen (23) angeordnet sind.

# FIG. 1

# FIG. 2

1

# FIG.3

# FIG. 4

# FIG. 5